# EUROPÄISCHE PATENTSCHRIFT

(11) **EP 2 462 637 B1**
(45) Veröffentlichungstag und Bekanntmachung des Hinweises auf die Patenterteilung: **02.04.2014**
(21) Anmeldenummer: 10740545.8
(22) Anmeldetag: 28.07.2010
(51) Int. Cl.: H01L 41/45, H01L 41/04

(54) **VERFAHREN ZUR HERSTELLUNG EINES ELEKTROMECHANISCHEN WANDLERS**
METHOD FOR PRODUCING AN ELECTROMECHANICAL CONVERTER
PROCÉDÉ DE FABRICATION D'UN CONVERTISSEUR ÉLECTROMÉCANIQUE

(30) Priorität: 07.08.2009 EP 09010202
(43) Veröffentlichungstag der Anmeldung: 13.06.2012
(73) Patentinhaber: Bayer Intellectual Property GmbH, 40789 Monheim (DE)
(72) Erfinder: JENNINGER, Werner, 50677 Köln (DE); WAGNER, Joachim, 51061 Köln (DE); BENECKE, Carsten, 79576 Weil am Rhein (DE); BERNERT, Thomas, 54331 Oberbillig (DE)
(74) Vertreter: BIP Patents
(86) Internationale Anmeldenummer: PCT/EP2010/004614
(87) Internationale Veröffentlichungsnummer: WO 2011/015303

(56) Entgegenhaltungen:
- US-A- 4 427 609
- US-A1- 2007 114 885
- SCHWODIAUER R ET AL: "Charging and switching of ferroelectrets. how much can ferroelectrets behave like ferroelectrics?" APPLICATIONS OF FERROELECTRICS, 2004. ISAF-04. 2004 14TH IEEE INTERNAT IONAL SYMPOSIUM ON MONTREAL, CANADA 23-27 AUG. 2004, PISCATAWAY, NJ, USA,IEEE, 23. August 2004 (2004-08-23), Seiten 134-137, XP010784520 ISBN: 978-0-7803-8410-1
- BASSO H C ET AL: "Three-layer ferroelectrets from perforated TeflonÂ TM -PTFE films fused between two homogeneous TeflonÂ TM -FEP films" 14. Oktober 2007 (2007-10-14), ELECTRICAL INSULATION AND DIELECTRIC PHENOMENA, 2007. CEIDP 2007. ANNUAL REPORT - CONFERENCE ON, IEEE, PISCATAWAY, NJ, USA, PAGE(S) 453 - 456 , XP031230601 ISBN: 978-1-4244-1481-9 in der Anmeldung erwähnt

## Beschreibung

Die vorliegende Erfindung betrifft ein Verfahren zur Herstellung eines elektromechanischen, beispielsweise piezoelektrischen, Wandlers, einen elektromechanischen Wandler sowie die Verwendung von elektromechanischen Wandlern.

Die Fähigkeit einiger Materialien, ein elektrisches Potential aufgrund einer ausgeübten mechanischen Belastung zu erzeugen, bezeichnet man als Piezoelektrizität. Etablierte piezoelektrische Materialien sind Blei-Zirkonium-Titanat (PZT) und fluorierte Polymere wie Polyvinylidenfluorid (PVDF). Piezoelektrisches Verhalten wurde auch in geschäumtem, geschlossenporigen Polypropylen (PP) beobachtet. Um Piezoelektrizität zu erreichen, wird ein solcher Polypropylenschaum in einem hohen elektrischen Feld aufgeladen. Dadurch finden innerhalb der Poren elektrische Durchschläge statt, welche Makrodipole generieren und das Material makroskopisch polarisieren. Derartige Polypropylenferroelektrete können einen piezoelektrischen Koeffizienten von einigen Hundert Pikocoulomb pro Newton aufweisen. Um die Sensitivität der Sensorwirkung weiter zu erhöhen, wurden Mehrschichtsysteme aus mehreren übereinander gestapelten Schäumen entwickelt.

Gerhard et al. (2007 Annual Report Conference on Electrical Insulation and Dielectric Phenomena, Seiten 453 bis 456) beschreibt ein Dreischichtferroelektret, in dem ein Polytetrafluorethylenfilm, welcher durch mechanisches oder laserbasiertes Bohren mit einer Vielzahl von gleichförmigen, durchgehenden Aussparungen versehen wurde, zwischen zwei gleichförmigen Fluorethylenpropylenfilmen angeordnet ist. Das Einbringen von durchgehenden Aussparungen durch mechanisches oder laserbasiertes Bohren ist jedoch aufwändig und für die Produktion großer Stückzahlen ungeeignet.

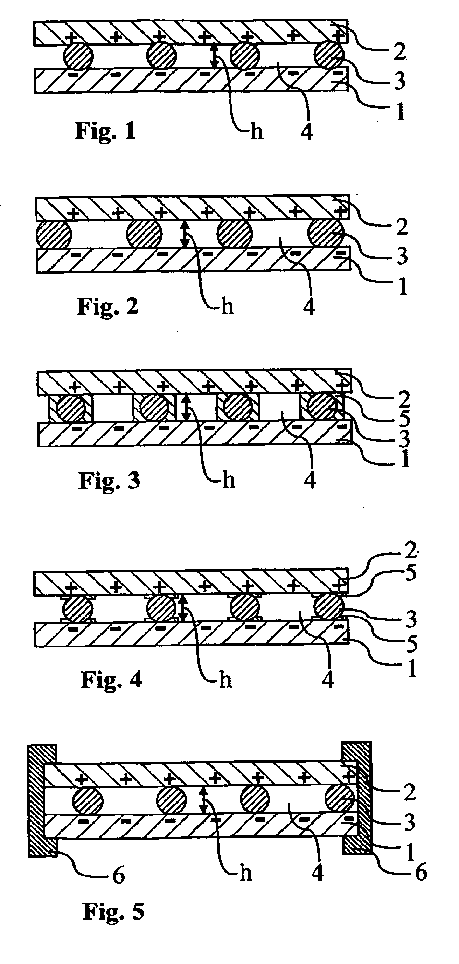

Schwödiauer et al. (2004 IEEE International Ultrasonics, Ferroelectrics, and Frequency Control Joint 50th Anniversary Conference) beschreibt eine Elektret Luftspalt-Sandwich-Struktur umfassend einen Polypropylenschaum zwischen zwei Elektroden, wie in den Fig. 1 (a) und (b) dieser Quelle dargestellt. Eine solche Struktur wird dadurch hergestellt, dass ein Polypropylenschaum, der Partikel enthält, in zwei Raumrichtungen verstreckt wird, wodurch Hohlräume entstehen. Dies ist in Fig. 1 (b) zu erkennen, wobei die hellen Bereiche das Polypropylengerüst und die dunklen Bereiche die abgeflachten Hohlräume zeigen. Deutlich zu erkennen ist die ungeordnete Struktur des Polypropylengerüsts und der dazwischen liegenden Hohlräume. Auch variieren offensichtlich die Dicke und die Form der "Streben" des Polymergerüsts und die Größe, der Durchmesser, die Höhe und die Form der Hohlräume stark, d.h die Größenverteilung sowohl der "Streben" als auch der Hohlräume ist hoch. Dabei ist die Variation der Höhe, d.h. des Durchmessers der Hohlräume rechtwinklig zu den Elektroden, besonders kritisch, da dies zu einer lokalen Variation der piezoelektrischen Eigenschaften, beispielsweise der piezoelektrischen Konstanten und deren Frequenzabhängigkeit, führt. Insbesondere sprechen die Lage der Resonanzfrequenz und die Breite des Resonanzpeaks der piezoelektrischen Konstanten stark auf eine Variation der vorgenannten Parameter an. Weiters führt die ungeordnete Struktur des Polypropylengerüsts und der dazwischen liegenden Hohlräume zu uneinheitlichen mechanischen Eigenschaften des Polypropylenschaums. Nachteilig bei einer solchen Anordnung ist also, dass die elektrischen und mechanischen Eigenschaften nur ungenau angepasst werden können.

Wünschenswert wäre, ein Verfahren zur Herstellung eines elektromechanischen, beispielsweise piezoelektrischen, Wandlers zur Verfügung zu stellen, welches zur Produktion großer Stückzahlen geeignet ist. Dieses Verfahren soll es außerdem ermöglichen, dass die elektrischen und mechanischen Eigenschaften des Wandler eingestellt werden können. Dazu soll es möglich sein, Strukturen nach Größe und Lage definiert und mit einer möglichst geringen Größenverteilung herzustellen.

Erfindungsgemäß vorgeschlagen wird daher ein Verfahren zur Herstellung eines elektromechanischen, beispielsweise piezoelektrischen, Wandlers, umfassend die Schritte:
A) Aufbringen einer Monolage aus Abstandselementen auf eine erste Polymerschicht, wobei die Abstandselemente der Monolage im Wesentlichen die gleiche Höhe aufweisen,
B) Aufbringen einer zweiten Polymerschicht auf die Abstandselemente der Monolage, so dass zwischen der ersten Polymerschicht und der zweiten Polymerschicht mindestens ein Hohlraum vorliegt, und
C) Fixieren der Abstandselemente zwischen der ersten und zweiten Polymerschicht.

Unter "Monolage" wird im Sinne der Erfindung eine einzelne Lage der Abstandselemente verstanden. Unter "im Wesentlichen die gleiche Höhe" wird im Sinne der Erfindung verstanden, dass die Abstandselemente im Rahmen der Produktionstoleranz, beispielsweise von weniger als 5 %, insbesondere von weniger als 1 %, die gleiche Höhe aufweisen.

Durch das erfindungsgemäße Verfahren können vorteilhafterweise elektromechanische Wandler in großen Stückzahlen hergestellt werden.

Die Monolage aus Abstandselementen kann den herzustellenden elektromechanischen Wandler vorteilhafterweise entlang seiner Dicke weicher machen, damit dessen Elastizitätsmodul erniedrigen, einen Polungsprozess in den resultierenden Hohlräumen ermöglichen und/oder nach dem Aufladungsprozess in den Polymerschichten gebildete Ladungsschichten separieren.

Unter einem "Abstandselement" kann insbesondere ein Element verstanden werden, welches vor dem Einbringen in das Verfahren eine definierte Form aufweist. Vorzugsweise bleibt diese Form bis zum Abschluss des Verfahrens im Wesentlichen erhalten. Die Abstandselemente können beispielsweise eine sphärolitische oder längliche Form aufweisen. Insbesondere können die Abstandselemente kugelförmig oder strangförmig (fadenförmig) ausgebildet sein. Der Abstand zwischen den Polymerfilmen kann vorteilhafterweise durch die Größe der Abstandselemente bestimmt werden. Die Dichte der Abstandselemente (Anzahl der Abstandselemente pro Flächeneinheit) und die Verteilung der Abstandselemente (mittlerer (maximaler) Abstand der Abstandselemente) kann entsprechend der mechanischen Eigenschaften der Polymerschichten geeignet gewählt werden.

Der Hohlraum beziehungsweise die Hohlräume sind insbesondere zwischen der ersten und der zweiten Polymerschicht durchgängig angeordnet. Zum Beispiel kontaktiert dabei der Hohlraum beziehungsweise kontaktieren dabei die Hohlräume auf einer Seite die erste Polymerschicht und auf der anderen Seite die zweite Polymehrschicht. Dies wirkt sich vorteilhaft auf das elektromechanische Verhalten des hergestellten elektromechanischen Energiewandlers aus.

In einer Ausführungsform des Verfahrens sind die Abstandselemente in Form von Kugeln, insbesondere von vollen oder hohlen Kugeln, und/oder Strängen, insbesondere von vollen oder hohlen Strängen (Schläuchen), ausgebildet. Vorzugsweise weisen die Abstandselemente eine möglichst geringe Größenverteilung auf. Insbesondere können die Abstandselemente der Monolage nicht nur im Wesentlichen die gleiche Höhe, sondern auch einen im Wesentlichen gleich großen Durchmesser aufweisen. Dabei kann unter "einen im Wesentlichen gleich großen Durchmesser" verstanden werden, dass die Abstandselemente im Rahmen der Produktionstoleranz, beispielsweise von weniger als 5 %, insbesondere von weniger als 1 %, den gleichen Durchmesser aufweisen. Auf diese Weise kann gewährleistet werden, dass der erste und zweite Polymerfilm äquidistant angeordnet werden können. Die Größe, insbesondere die Höhe und/oder der Durchmesser, der Abstandselemente wird vorzugsweise derart eingestellt, dass sich die Polymerschichten nicht berühren können und/oder dass das nach Fertigstellung resultierende Gesamthohlraumvolumen möglichst groß ist. Beispielsweise können die Abstandselemente eine Höhe von ≥ 1 µm bis ≤ 800 µm, bevorzugt von ≥ 10 µm bis ≤ 300 µm, besonders bevorzugt von ≥ 20 µm bis ≤ 200 µm, ganz besonders bevorzugt von ≥ 50µm bis ≤100 µm und/oder einen Durchmesser von ≥ 1 µm bis ≤ 800 µm, bevorzugt von ≥ 10 µm bis ≤ 300 µm, besonders bevorzugt von ≥ 20 µm bis ≤ 200 µm, ganz besonders bevorzugt von ≥ 50 µm bis ≤ 100 µm aufweisen. Vorzugsweise sind die Abstandselemente aus einem elektrisch nicht leitenden und/oder elektrisch nicht polarisierbaren Material ausgebildet.

Die Abstandselemente können sowohl homogen als auch heterogen verteilt auf der ersten Polymerschicht aufgebracht werden. Insbesondere können die Abstandselemente auf der ersten Polymerschicht homogen verteilt aufgebracht werden. In Abhängigkeit vom Anwendungsbereich des herzustellenden elektromechanischen Wandlers, kann es jedoch auch vorteilhaft sein, die Abstandselemente, insbesondere gezielt, ortsaufgelöst heterogen verteilt aufzubringen.

Weiterhin können die Abstandselemente in unterschiedlichen Formen ausgebildet sein. Insbesondere kann eine Vielzahl an in einer ersten Form ausgebildeten Abstandselementen und eine Vielzahl an in einer zweiten Form ausgebildeten Abstandselementen und gegebenenfalls eine Vielzahl an in einer dritten Form ausgebildeten Abstandselementen, et cetera, aufgebracht werden. Dabei können die in unterschiedlichen Formen ausgebildeten Abstandselemente auf der ersten Polymerschicht homogen oder heterogen verteilt aufgebracht werden. Insbesondere können die elektromechanischen, insbesondere piezoelektrischen, Eigenschaften der mit dem erfindungsgemäßen Verfahren hergestellten, elektromechanischen Wandler durch Auswahl der Abstandselementform, Abstandselementanordnung und/oder Abstandselementverteilung angepasst werden.

Die Abstahdselemente können grundsätzlich unabhängig voneinander aus jedem Material ausgebildet sein, welches geeignet ist, einen Polungsprozess in den Hohlräumen zu ermöglichen und die nach dem Aufladungsprozess in den Polymerschichten gebildeten Ladungsschichten zu separieren.

In einer weiteren Ausführungsform des Verfahrens sind die Abstandselemente aus Glas oder einem Polymer ausgebildet. Zum Beispiel können die Abstandselemente aus Mineralglas, insbesondere Kieselglas oder Quarzglas, ausgebildet sein. Polymere zur Ausbildung von Abstandselementen können fast beliebig gewählt werden. Exemplarisch seien Thermoplaste, wie Polycarbonate und Polystyrole, insbesondere Polycarbonate, und thermoplastische Elastomere, wie thermoplastische Polyurethane (TPU), genannt. Zum Beispiel vertreibt die Firma Liquid Crystal Technologies (LCT) (Cleveland, Ohio, Vereinigte Staten von Amerika) geeignete polymere Abstandselemente. Insbesondere können die Abstandselemente in Form von Glaskugeln und/oder Polymerkugeln und/oder Glassträngen und/oder Polymersträngen ausgebildet sein.

In einer weiteren Ausführungsform des Verfahrens sind die Abstandselemente strangförmig ausgebildet und werden mäanderförmig auf die erste Polymerschicht aufgebracht. Auf diese Weise können strangförmige, beispielsweise flexible, Abstandselemente unter Vermeidung von übereinander liegenden Strängen angeordnet werden.

Während des Aufbringens der Abstandselemente können die Abstandselemente verteilt, insbesondere gespreitet, werden.

In einer weiteren Ausführungsform des Verfahrens erfolgt das Aufbringen der Abstandselemente auf die erste Polymerschicht in Verfahrensschritt A) durch ein Streuverfahren und/oder ein Sprühverfahren und/oder ein Wirbelschichtverfahren und/oder ein Bestückungsverfahren (insbesondere eine Bestückungstechnik, beispielsweise mit einem Bestückungsautomaten) und/oder ein Druckverfahren und/oder ein Beschichtungsverfahren.

In einer weiteren Ausführungsform des Verfahrens erfolgt das Aufbringen der Abstandselemente auf die erste Polymerschicht in Verfahrensschritt A) durch ein Druck- und/oder Beschichtungsverfahren, wobei ein Druck- und/oder Beschichtungsmaterial, beispielsweise eine Druckfarbe, eine Tinte, eine Paste, eine Formulierung, ein Lack oder ein Klebstoff, eingesetzt wird, welches die Abstandselemente als Füllstoffe umfasst.

Nach dem Aufbringen der Monolage aus Abstandselementen auf die erste Polymerschicht in Verfahrensschritt A) kann das Druck- und/oder Beschichtungsmaterial teilweise oder vollständig verfestigt, beispielsweise getrocknet und/oder vernetzt und/oder erstarrt und/oder kristallisiert, werden. Dies kann beispielsweise thermisch, durch Bestrahlen mit ultraviolettem Licht, durch Bestrahlen mit Infrarotlicht und/oder durch Trocknen erfolgen. Wenn der Aufbau jedoch Polymere mit einer geringen UV-Stabilität, wie Polycarbonate, enthält, so erfolgt eine Verfestigung vorzugsweise thermisch, durch Bestrahlung mit Infrarotlicht und/oder durch Trocknen. Durch zunächst teilweises und anschließend vollständiges Verfestigen kann zum Einen die Formbeständigkeit der gedruckten Strukturen verbessert werden. Zum anderen bietet dies die Möglichkeit, durch anschließendes weiteres, insbesondere vollständiges, Verfestigen die Abstandselemente zwischen der ersten und zweiten Polymerschicht zu fixieren beziehungsweise die Monolage aus Abstandselementen sowohl mit der ersten Polymerschicht als auch mir der zweiten Polymerschicht zu verbinden.

Der Verfahrerisschritt C) känn sowohl nach den Verfahrensschritten A) und B) als auch während und/oder vor den Verfahrensschritten A) und/oder B) durchgeführt werden.

Zum Beispiel erfolgt in einer weiteren Ausführungsform des Verfahrens das Fixieren der Abstandelemente durch nur teilweises Verfestigen, beispielsweise Trocknen und/oder Vernetzen und/oder Erstarren und/oder Kristallisieren, des Abstandselemente umfassenden Druck- und/oder Beschichtungsmaterials nach dem Aufbringen der Monolage aus Abstandselementen in Verfahrensschritt A) und durch vollständiges Verfestigen, beispielsweise Trocknen und/oder Vernetzen und/oder Erstarren und/oder Kristallisieren, des Abstandselemente umfassenden Druck- und/oder Beschichtungsmaterials nach dem Aufbringen der zweiten Polymerschicht in Verfahrensschritt B).

In einer weiteren Ausführungsform des Verfahrens erfolgt das Fixieren der Abstandselemente durch ein Klebeverfahren, wobei vor dem Verfahrensschritt A) im Verfahrensschritt 0) auf die Abstandselemente und/oder die erste Polymerschicht und/oder die zweite Polymerschicht eine Klebemittelschicht, insbesondere durch Aufbringen eines Druck- und/oder Beschichtungsmaterials durch ein Druck- und/oder Beschichtungsverfahren, aufgebracht wird/ist. Dabei kann das eigentliche Fixieren während und/oder nach Verfahrensschritt A) und/oder während und/oder nach Verfahrensschritt B) erfolgen. In diesem Zusammenhang sowie im Zusammenhang mit dem im folgenden erläuterten Laminierungsverfahren kann das Verfahren vor dem Verfahrensschritt A) auch den Verfahrensschritt 0): Aufbringen einer Klebemittelschicht und/oder einer thermoplastischen Schicht auf die Abstandselemente und/oder die erste Polymerschicht und/oder die zweite Polymerschicht, insbesondere durch ein Druck- und/oder Beschichtungsverfahren, umfassen.

In einer weiteren Ausführungsform des Verfahrens erfolgt das Fixieren der Abstandelemente durch ein Laminierungsverfahren, insbesondere unter erhöhtem Druck und/oder bei einer erhöhten Temperatur und/oder unter Bestrahlung mit ultraviolettem Licht und/oder unter Bestrahlung mit Infrarotlicht, wobei vor dem Verfahrensschritt A) im Verfahrensschritt 0) auf die Abstandselemente und/oder die erste Polymerschicht und/oder die zweite Polymerschicht eine thermoplastische Schicht, insbesondere durch Aufbringen eines Druck- und/oder Beschichtungsmaterials durch ein Druck- und/oder Beschichtungsverfahren, aufgebracht wird/ist, und/oder die Abstandselemente und/oder die erste Polymerschicht und/oder die zweite Polymerschicht aus einem thermoplastischen Material ausgebildet sind. Das Laminieren unter erhöhtem Druck und/oder bei einer erhöhten Temperatur kann zum Beispiel zwischen zwei heißen, sich drehenden Zylindern erfolgen. Der Druck und/oder die Temperatur werden dabei vorzugsweise derart ausgewählt, dass sich die Polymerschichten und Abstandselemente verbinden, wobei die Form der Abstandselemente, zumindest im Wesentlichen, erhalten bleibt. Im Rahmen des Laminierungsverfahrens können die Abstandselemente und/oder die erste Polymerschicht und/oder die zweite Polymerschicht und/oder die thermoplastische/n Schicht/en erwärmt werden. Darüber hinaus kann das Verfahren den Verfahrensschritt **C1):** Anbringen einer Versiegelung, welche den durch die Abstandselemente aufgespannten und an zwei Seiten von den Polymerschichten begrenzten Raum an den übrigen Seiten begrenzt und versiegelt, aufweisen.

In einer weiteren Ausführungsform des Verfahrens erfolgt das Fixieren der Abstandelemente durch ein Klemmverfahren, wobei die erste Polymerschicht und die zweite Polymerschicht durch eine oder mehrere Klemmen zusammengeklemmt werden. Die Klemme beziehungsweise die Klemmen können dabei gleichzeitig als Versiegelung ausgestaltet sein. Beim Fixieren durch ein Klemmverfahren können die Abstandselemente gegebenenfalls leicht in die erste Polymerschicht und/oder die zweite Polymerschicht hineingedrückt werden, wobei sich die erste Polymerschicht und/oder die zweite Polymerschicht geringfügig verformt und die Abstandselemente in der jeweiligen Position fixiert werden. Alternativ oder zusätzlich dazu können die Abstandselemente selbst geringfügig verformt werden und auf diese Weise zwischen der ersten Polymerschicht und der zweiten Polymerschicht fixiert werden.

Die Klebemittelschicht kann nach dem Aufbringen im Verfahrensschritt 0) teilweise verfestigt, beispielsweise getrocknet und/oder vernetzt und/oder erstarrt und/oder kristallisiert, werden. Dies kann thermisch, durch Bestrahlen mit ultraviolettem Licht, durch Bestrahlen mit Infrarotlicht und/oder durch Trocknen erfolgen. Vorzugsweise wird die Klebemittelschicht dabei jedoch nur insoweit verfestigt, dass die Klebeeigenschaften erhalten bleiben und die Abstandselemente daran haften können. Nach dem Aufbringen der Monolage aus Abstandselementen, insbesondere im Verfahrensschritt A), kann die Klebemittelschicht vollständig verfestigt, beispielsweise getrocknet und/oder vernetzt und/oder erstarrt und/oder kristallisiert, und die Abstandselemente auf diese Weise fixiert werden.

Die thermoplastische Schicht kann nach dem Aufbringen im Verfahrensschritt 0) vollständig verfestigt, beispielsweise getrocknet und/oder vernetzt und/oder erstarrt und/oder kristallisiert, werden. Dies kann ebenfalls thermisch, durch Bestrahlen mit ultraviolettem Licht, durch Bestrahlen mit Infrarotlicht und/oder durch Trocknen erfolgen.

In einer weiteren Ausführungsform des Verfahrens ist die Klebemittelschicht und/oder die thermoplastische Schicht eine strukturierte Schicht. Vorzugsweise sind daher die Klebemittelschicht und/oder die thermoplastische Schicht aus einem Material ausgebildet, welches in definierten Strukturen auf die erste Polymerschicht aufbringbar ist. Eine Strukturierung der Klebemittelschicht und/oder der thermoplastischen Schicht kann beispielsweise derart ausgestaltet sein, dass nur diejenigen Bereiche der ersten Polymerschicht, auf denen anschließend Abstandselemente aufgebracht werden, teilweise oder vollständig mit der Klebemittelschicht beziehungsweise der thermoplastischen Schicht beschichtet werden. Auf diese Weise sind die Bereiche der ersten Polymerschicht, welche den entstehenden Hohlraum begrenzen unbeschichtet, was sich vorteilhaft auf die piezoelektrischen Eigenschaften des hergestellten elektromechanischen Wandlers auswirken kann.

Zum Beispiel können die Abstandselemente im anschließenden Verfahrensschritt A), beispielsweise durch ein Bestückungsverfahren, nur auf die Bereiche der ersten Polymerschicht aufgebracht werden, welche die Klebemittelschicht beziehungsweise die thermoplastische Schicht aufweisen.

Die Abstandselemente können im anschließenden Verfahrensschritt A), jedoch auch sowohl auf die Bereiche der ersten Polymerschicht aufgebracht werden, welche die Klebemittelschicht beziehungsweise thermoplastische Schicht aufweisen, als auch auf die Bereiche der ersten Polymerschicht aufgebracht werden, welche keine Klebemittelschicht beziehungsweise keine thermoplastische Schicht aufweisen.

In einer weiteren Ausführungsform des Verfahrens umfasst das Verfahren nach dem Verfahrensschritt A) den Verfahrensschritt A1): Entfernen von nicht auf der Klebemittelschicht und/oder thermoplastischen Schicht haftenden Abstandselementen. Dies kann beispielsweise durch ein Schüttelverfahren, insbesondere mit nach unten gerichteter Abstandselemente aufweisenden Seite der Polymerschicht, und/oder unter zu Hilfenahme eines Luftstroms erfolgen

Beispielsweise können die Abstandselemente auf eine Klebemittelschicht und/oder thermoplastische Schicht durch Aufsprühen, Aufstreuen oder Aufwirbeln aufgebracht werden. Auf den Bereichen der ersten Polymerschicht, welche mit der Klebemittelschicht versehen sind, haften die Abstandselemente an unbehandelten Bereichen hingegen nicht. Durch Schütteln oder Abklopfen können die nicht auf der Klebemittelschicht haftenden Abstandselemente entfernt werden. Nach dem Aufbringen der Abstandselemente kann die Klebemittelschicht vernetzt und/oder getrocknet, insbesondere vollständig vernetzt und/oder getrocknet werden, beispielsweise um die aufgebrachten Abstandselemente endgültig zu fixieren

Das Aufbringen der Klebemittelschicht und/oder der thermoplastischen Schicht kann ebenfalls durch ein Druck- und/oder Beschichtungsverfahren, insbesondere mit einem Druck- und/oder Beschichtungsmaterial, beispielsweise eine Druckfarbe, eine Tinte, eine Paste, eine Formulierung, ein Lack oder ein Klebstoff, erfolgen.

Im Rahmen der vorliegenden Erfindung eignen sich als Druck- und/oder Beschichtungsverfahren beispielsweise Rakeln, Lackschleudern (Spincoating), Tauchlackieren (Dipcoating), Sprühlackieren (Spraycoating), Vorhanggießen (Curtaincoating), Düsenauftrag (Slot-dye-coating), Flexodruck, Grawrdruck, Tampondruck, Digitaldruck, Thermotransferdruck, Durchdruck, insbesondere Hochdruck, Flachdruck, Tiefdruck (Offsetdruck) und/oder Siebdruck, und/oder ein Walzenauftragsverfahren, beispielsweise mit Walzenauftragswerken für Hotmelt-Klebstoffe von der Firma Hardo Maschinenbau GmbH (Bad Salzuflen, Deutschland), vorzugsweise Siebdruck. Insbesondere kann eine strukturierte Schicht durch Rakeln, Lackschleudern (Spincoating), Tauchlackieren (Dipcoating), Sprühlackieren (Spraycoating) und/oder Vorhanggießen (Curtaincoating) in Kombination mit Matrizen, Masken oder Schablonen aufgebracht werden, wobei die Schablone die entsprechende Polymerschicht insbesondere an den Stellen, die nicht beschichtet werden sollen, verdeckt. Als Beschichtungsverfahren ohne Matrizen, Masken oder Schablonen können insbesondere Beschichtung mittels Düsenauftrag (Slot-dye-coating), Flexodruck, Gravurdruck, Tampondruck, Digitaldruck, Thermotransferdruck, Durchdruck, insbesondere Hochdruck, Flachdruck, Tiefdruck (Offsetdruck) und/oder ein Walzenauftragsverfahren, vorzugsweise ein Siebdruckverfahren, verwendet werden.

Das Druck- und/oder Beschichtungsmaterial, beispielsweise die Druckfarbe, die Tinte, die Paste, die Formulierung, der Lack oder der Klebstoff, kann sowohl direkt vor der Verarbeitung formuliert werden als auch kommerziell erhältlich sein.

Beispielsweise kann das Druck- und/oder Beschichtungsmaterial mindestens ein Polymer ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen, insbesondere Polyurethanen, und Mischungen dieser Polymere, insbesondere als Bindemittel, umfassen beziehungsweise daraus ausgebildet sein. Insofern das Druck- und/oder Beschichtungsmaterial ein Harz umfasst, kann das Druck- und/oder Beschichtungsmaterial gegebenenfalls weiterhin einen oder mehrere Harzhärter umfassen. Weiterhin kann das Druck- und/oder Beschichtungsmaterial Lösungsmittel, Additive und andere Füllstoffe umfassen. Als Additive können dem Druck- und/oder Beschichtungsmaterial beispielsweise Verdicker, Rheologieadditive, Haftvermittler, Entschäumer, Entlüfter und/oder Verlaufsmittel zugesetzt werden/sein.

Als Druck- und/oder Beschichtungsmaterial können eine Vielzahl von kommerziell erhältlichen Produkten, insbesondere als Bindemittel, geeignet sein, welche beispielsweise unter den Handelsnamen Noriphan HTR, Noriphan PCI, Noriphan N2K, Noricryl und NoriPET von der Firma Pröll KG, Weißenburg in Bayern, Deutschland, oder unter dem Handelsnamen Maraflex FX von der Firma Marabu GmbH & Co. KG, Tamm, Deutschland, oder unter dem Handelsnamen Polyplast PY von der Firma Fujifilm Sericol Deutschland GmbH, Bottrop, Deutschland, oder unter den Handelsnamen Siebdruckfarben HG, SG, CP, CX, PK, J, TL sowie YN von der Firma Coates Screen Inks GmbH, Nürnberg, Deutschland, oder unter den Handelsnamen 1500 Series UV Flexiform, 1600 Power Print Series, 1700 Versa Print, 3200 Series, 1800 Power Print plus, 9700 Series, PP Series, 7200 Lacquer und 7900 Series von der Firma Nazdar, Shawnee, Vereinigte Staaten von Amerika, vertrieben werden.

Als Bindemittel für ein Druck- und/oder Beschichtungsmaterial, welches unter ultraviolettem Licht härtet, eignen sich beispielsweise Epoxy-, Ester-, Ether- und/oder Urethanacrylate. Urethanacrylate können als Lösungen in Reaktivverdünnern (niederviskose Meth-/Acrylsäureester), als niederviskose Oligomere, als Feststoffe für die Pulverlacktechnologie oder als Urethanacrylat-Dipsersionen eingesetzt werden. Urethanacrylate sind beispielsweise unter dem Handels/Markennamen Desmolux von der Firma Bayer MaterialScience AG (Leverkusen, Deutschland) erhältlich. Zur Härtung eignen sich beispielsweise Elektronenstrahlhärtung, Mono Cure Technologie und Dual Cure Technologie. Für die Dual Cure Technologie sind Isocyanatourethanacryle besonders geeignet.

Das Druck- und/oder Beschichtungsmaterial kann auf Wasserbasis oder auf der Basis anderer Lösungsmittel als Wasser aufgebaut sein.

Das Druck- und/oder Beschichtungsmaterial kann insbesondere ein oder mehr Polyurethane umfassen oder daraus ausgebildet sein. Insbesondere kann das Druck- und/oder Beschichtungsmaterial ein oder mehrere Einkomponenten-Polyurethane und/oder ein oder mehrere Zweikomponenten-Polyurethane und/oder eine oder mehrere wässrige Polyurethandispersionen und/oder einen oder mehrere Polyurethan-Schmelzklebstoffe umfassen oder daraus ausgebildet sein.

Beispielsweise kann das Druck- und/oder Beschichtungsmaterial ein oder mehrere Einkomponenten-Polyurethane umfassen oder daraus ausgebildet sein, welche Prepolymere, herstellbar durch Reaktion von Alkoholen mit einem stöchiometrischen Überschuss von polyfunktionellen Isocyanaten mit einer mittleren Funktionalität größer als 2 und bis zu 4, umfassen. Diese Prepolymere können gegebenenfalls weiterhin Zusatzstoffe und/oder Lösungsmittel umfassen.

Die Prepolymere können beispielsweise durch Umsetzung von Polyisocyanaten mit Alkoholen, die Mischungen von Polyolen mit im Mittel monofunktionellen Alkoholen darstellen, unter Ausbildung von Urethangruppen und endständigen Isocyanatgruppen erhalten werden.

Als Polyole können die dem Fachmann bekannten, in der Polyurethanchemie üblichen Polyole, wie beispielsweise Polyether-, Polyacrylat-, Polycarbonat-, Polycaprolacton-, Polyurethan- und Polyester-Polyole verwendet werden, wie sie zum Beispiel in Ullmanns Enzyklopädie der technischen Chemie, 4. Auflage, Band 19, S. 304-5, Verlag Chemie, Weinheim, oder in Polyurethan Lacke, Kleb- und Dichtstoffe von Ulrich Meier-Westhues, Vincentz Network, Hannover, 2007, beschrieben sind. Zum Beispiel können die Desmophen ® genannten Polyole der Firma Bayer MaterialScience AG, Leverkusen, Deutschland, verwendet werden.

Als polyfunktionelle Isocyanate mit einer mittleren Funktionalität > 2 können die in der Polyurethanchemie üblichen, dem Fachmann bekannten Produkte eingesetzt werden, wie sie zum Beispiel in Ullmanns Enzyklopädie der technischen Chemie, 4. Auflage, Band 19, S. 303-4, Verlag Chemie, Weinheim, beschrieben sind. Als Beispiele seien über Biuretgruppen trimerisierte Isocyanate, wie etwa trimerisiertes Hexamethylendiisocyanat Desmodur ® N (Handelsname der Firma Bayer MaterialScience AG, Leverkusen, Deutschland), oder deren Gemische mit Diisocyanaten oder über Isocyanuratgruppen trimerisierte Isocyanate oder ihre Gemische mit Diisocyanaten genannt. Auch die Addukte von Diisocyanaten an Polyole, beispielsweise von Toluylendiisocyanat an Trimethylolpropan sind geeignet.

Den Prepolymeren können Zusatzstoffe wie Katalysatoren zur Beschleunigung der Aushärtung, beispielsweise tertiäre Amine wie Dimorpholinodiethylether, Bis-[2-N,N-(dimethylamino)ethyl]ether oder Zinnverbindungen, wie Dibutylzinndilaurat oder Zinn-II-octoat, Alterungs- und Lichtschutzmittel, Trockenmittel, Stabilisatoren, beispielsweise Benzoylchlorid, Haftvermittler zur Verbesserung der Adhäsion, Weichmacher, beispielsweise Dioctylphthalat, sowie Pigmente und Füllstoffe zugegeben werden.

Wegen der Feuchtigkeitsempfindlichkeit der Isocyanate sollte in der Regel unter sorgfältigem Ausschluss von Wasser gearbeitet werden, das heißt es sollten wasserfreie Rohstoffe eingesetzt werden und der Zutritt von Feuchtigkeit während der Reaktion vermieden werden.

Die Herstellung der Prepolymere kann durch Umsetzung des Gemisches aus Polyolen und monofunktionellem Alkohol mit einem stöchiometrischen Überschuss von di- oder polyfunktioneller Isocyanatverbindung erfolgen. Es ist jedoch auch möglich, die monofunktionelle Hydroxylverbindung in einer vorgeschalteten Reaktion mit der Isocyanatverbindung umzusetzen.

Das Druck- und/oder Beschichtungsmaterial kann jedoch auch ein oder mehrere Zweikomponenten-Polyurethane umfassen oder daraus ausgebildet sein, welche beispielsweise eine Komponente mit Isocyanatgruppen und eine isocyanatreaktive Komponente umfassen.

Als geeignete Polyisocyanate für das Druck- und/oder Beschichtungsmaterial können die dem Fachmann an sich bekannten NCO-funktionellen Verbindungen einer Funktionalität von bevorzugt 2 oder mehr Verwendung finden. Dies sind typischerweise aliphatische, cycloaliphatische, araliphatische und/oder aromatische Di- oder Triisocyanate sowie deren höhermolekulare Folgeprodukte mit Iminooxadiazindion-, Isocyanurat-, Uretdion-, Urethan-, Allophanat-, Biuret-, Harnstoff-, Oxadiazintrion-, Oxazolidinon-, Acylhamstoff- und/oder Carbodiimid-Strukturen, die zwei oder mehr freie NCO-Gruppen aufweisen.

Beispiele für solche Di- oder Triisocyanate sind Tetramethylendiisocyanat, Cyclohexan-1,3- und 1,4-diisocyanat, Hexamethylendiisocyanat (HDI), 1-Isocyanato-3,3,5-trimethyl-5-isocyanatomethyl-cyclohexan (Isophorondiisocyanat, IPDI), Methylen-bis-(4-isocyanatocyclohexan), Tetramethylxylylendiisocyanat (TMXDI), Triisocyanatononan, Toluylendiisocyanat (TDI), Di-phenylmethan-2,4'-und/oder -4,4'-und/oder -2,2'-diisocyanat (MDI), Triphenylmethan-4,4'-diisocyanat, Naphtyten-1,5-diisocyanat, 4-Isocyanatomethyl-1,8-octandiisocyanat (Nonantriisocyanat, Triisocyanatononan, TIN) und/oder 1,6,11 - Undecantriisocyanat sowie deren beliebige Mischungen und gegebenenfalls auch Mischungen anderer Di-, Tri- und/oder Polyisocyanate. Solche Polyisocyanate haben typischerweise Isocyanatgehalte von 0,5 Gewichtsprozent bis 60 Gewichtsprozent, bevorzugt 3 Gewichtsprozent bis 30 Gewichtsprozent, besonders bevorzugt 5 Gewichtsprozent bis 25 Gewichtsprozent.

Bevorzugt werden in dem Druck- und/oder Beschichtungsmaterial die höhermolekularen Verbindungen mit Isocyanurat-, Urethan-, Allophanat-, Biuret-, Iminooxadiazintrion-, Oxadiazintrion- und/oder Uretdiongruppen auf Basis aliphatischer und/oder cycloaliphatischer und/oder aromatischer Diisocyanate eingesetzt.

Besonders bevorzugt werden in dem Druck- und/oder Beschichtungsmaterial Verbindungen mit Biuret-, Iminooxadiazindion,- Isocyanurat- und/oder Uretdiongruppen auf Basis von Hexamethylendiisocyanat, Isophorondiisocyanat, 4,4'-Diisocyanatodicyclohexylmethan, Diphenylmethan-4,4'-diisocyanat, Diphenylmethan-2,4'-diisocyanat, 2,4-Toluylendiisocyanat 2,6-Toluylendiisocyanat und/oder Xylylendiisocyanat eingesetzt.

Die Herstellung und/oder Verwendung der isocyanathaltigen Komponente kann in einem Lösemittel erfolgen, Beispiele sind N-Methylpyrrolidon, N-Ethylpyrrolidon, Xylol, Solvent Naphtha, Toluol, Butylacetat, Methoxypropylacetat, Aceton oder Methylethylketon. Es ist möglich, nach der Abreaktion der Isocyanatgruppen Lösemittel hinzu zu geben. Hierbei können auch protische Lösemittel wie Alkohole zum Einsatz kommen, die beispielsweise der Stabilisierung der Lösung oder der Verbesserung von Lackeigenschaften dienen. Es sind auch beliebige Mischungen von Lösemitteln möglich. Die Menge Lösemittels wird im allgemeinen so bemessen, dass 20 gewichtsprozentige bis < 100 gewichtsprozentige, vorzugsweise 50 gewichtsprozentige bis 90 gewichtsprozentige Lösungen resultieren.

Zur Beschleunigung der Vernetzung können auch Katalysatoren zugesetzt werden. Geeignete Katalysatoren sind in "Polyurethane Chemistry and Technology", Volume XVI, Part 1, Abschnitt IV, Seiten 129 - 211, The Kinetics and Catalysis of the Isocyanate Reactions, beschrieben. Beispielsweise sind tertiäre Amine, Zinn-, Zink- oder Wismutverbindungen, oder basische Salze geeignet. Bevorzugt sind Dibutylzinndilaurat und -octoat.

Geeignete isocyanatreaktive Komponenten wie beispielsweise Polyhydroxylverbindungen sind dem Fachmann an sich bekannt. Bevorzugt sind dies die an sich bekannten Bindemittel auf Basis von Polyhydroxypolyestern, Polyhydroxypolyurethanen, Polyhydroxypolyethem, Polycarbonat-Diolen oder von Hydroxylgruppen aufweisenden Polymerisaten, wie den an sich bekannten Polyhydroxypolyacrylaten, Polyacrylatpolyurethanen und/oder Polyurethanpolyacrylaten. Als Beispiele seien die Desmophen ® genannten Polyole der Firma Bayer MaterialScience AG, Leverkusen, Deutschland, genannt.

Das Druck- und/oder Beschichtungsmaterial kann jedoch auch eine oder mehrere wässrige Polyurethandispersionen, beispielsweise eine Polyurethan-Polyharnstoffdispersion, umfassen oder aus einer solchen ausgebildet sein. Geeignete wässrige Polyurethandispersionen für ein Druck- und/oder Beschichtungsmaterial zur Herstellung eines erfindungsgemäßen elektromechanischen Wandlers sind solche, wie sie beispielsweise in US 2,479,310 A, US 4,092,286 A, DE 2 811 148 A, DE 3603996 und EP 08019884 beschrieben sind.

Geeignete Diol- und /oder Polyolkomponenten für die Herstellung von Polyurethan-Polyharnstofidispersionen sind Verbindungen mit mindestens zwei gegenüber Isocyanaten reaktionsfähigen Wasserstoffatomen und einem mittleren Molekulargewicht von ≥ 62 bis ≤ 18000, bevorzugt ≥ 62 bis ≤ 4000 g/mol. Beispiele für geeignete Aufbaukomponenten sind Polyether, Polyester, Polycarbonat, Polylactone und Polyamide. Bevorzugte Polyole weisen ≥ 2 bis ≤ 4 bevorzugt ≥2 bis ≤3 3 Hydroxylgruppen auf. Auch Gemische verschiedener derartiger Verbindungen kommen in Frage.

Die Polyurethan-Polyharnstoff-Dispersion kann sowohl alleine als auch in Kombination mit einem oder mehreren hydrophil modifizierten Vernetzern verwendet werden. Die zusätzliche Vernetzung des Polyurethan-Polyhamstoff-Polymers bewirkt eine deutliche Erhöhung der Wärmebeständigkeit und der Hydrolysebeständigkeit der Klebeverbindung.

Auch eine oder mehrere latent-reaktive Polyurethan-Polyharnstoff-Dispersionen können eingesetzt werden. Latent-reaktive Polyurethan-Polyharnstoff-Dispersionen sind beispielsweise in EP 0 922 720 A und WO 2008/071307 beschrieben. Der Vorteil dieser Produktklasse liegt darin, dass die Vernetzungsreaktion des Polymers beispielsweise durch Erwärmung im Rahmen eines Laminierprozesses ausgelöst werden kann.

Die Dispersion kann alleine oder mit den in der Beschichtungs- und Klebstofftechnologie bekannten Bindemitteln, Hilfsstoffen und/oder Zugschlagstoffen, insbesondere Emulgatoren und Lichtschutzmitteln, wie UV-Absorbern und sterisch gehinderte Aminen (HALS), Antioxidantien, Füllstoffen, Antiabsetzmitteln**,** Entschäumungsmitteln, Netzmitteln, Verlaufmitteln, Reaktiv-Verdünnern, Weichmachern, Neutralisationsmitteln, Katalysatoren, Hilfslösemitteln und/oder Verdickern und/oder Additiven, wie Pigmenten, Farbstoffen oder Mattierungsmitteln, eingesetzt werden. Auch Klebrigmacher ("Tackifier") können zugegeben werden. Die Additive können dabei unmittelbar vor der Verarbeitung zugegeben werden. Es ist aber auch möglich, zumindest einen Teil der Additive vor oder während der Dispergierung des Bindemittels zuzugeben.

Die Auswahl und die Dosierung dieser Stoffe, die den Einzelkomponenten und/oder der Gesamtmischung zugegeben werden können, sind dem Fachmann prinzipiell bekannt und können ohne ungebührlich hohen Aufwand auf den speziellen Anwendungsfall zugeschnitten durch einfache Vorversuche ermittelt werden.

Die Rheologie der wässrigen Polyurethandispersionen wird vorzugsweise mit geeigneten Verdickern so eingestellt, dass diese nach dem Aufbringen, beispielsweise auf die Polymerschicht, nicht mehr verläuft. Insbesondere die Strukturviskosität der Fließgrenze kann dabei hoch sein. Der Einsatz einer derartigen wässrigen Polyurethandispersion hat den Vorteil, dass die Druckschicht und/oder Beschichtung nach dem Aufbringen zunächst getrocknet werden kann, wobei das Polyurethanpolymer - in Abhängigkeit von dem eingesetzten Polymer oder Polymergemisch - amorph erstarrt und/oder kristallisiert und die Druckschicht und/oder Beschichtung in einem nachfolgenden Laminierungsverfahren gerade soweit erwärmt werden kann, dass das Polyurethanpolymer erweicht und/oder schmilzt und die Polymerschicht benetzt wird, wobei die Struktur der die Abstandshalter enthaltenden Schicht erhalten bleibt.

Weiterhin kann das Verfahren den Verfahrensschritt A2) umfassen: Aufbringen, insbesondere deckungsgleiches Aufbringen, mindestens einer weiteren Monolage aus Abstandselementen auf die vorherige Monolage. Vorzugsweise wird dabei jeweils ein Abstandselement der weiteren Monolage auf einem entsprechenden Abstandselement der vorherigen Monolage, insbesondere deckungsgleich, aufgebracht. Auf diese Weise kann zwischen der ersten und zweiten Polymerschicht mindestens ein, insbesondere durchgängiger, Hohlraum entstehen. Vorzugsweise weisen die Abstandselemente der weiteren Monolage, insbesondere untereinander, ebenfalls im Wesentlichen die gleiche Höhe auf. Das Fixieren der Abstandselemente der weiteren Monolage kann analog zum bereits erläuterten Fixieren der (ersten) Monolage erfolgen, wobei auf die Offenbarung in diesem Zusammenhang hiermit explizit hingewiesen wird.

Bei der ersten und/oder zweiten Polymerschicht handelt es sich vorzugsweise um kompakte und/oder durchgehende Polymerschichten. Dabei bedeutet der Begriff "kompakt" im Sinn der vorliegenden Erfindung, dass die Polymerschichten möglichst wenige, insbesondere keine, Einschlüsse wie Gasblasen aufweisen. Insbesondere kann es sich bei den Polymerschichten um Polymerfilme handeln. Die erste und/oder zweite Polymerschicht können grundsätzlich unabhängig voneinander durch alle bekannten Verfahren zur Herstellung von, insbesondere dünnen, Schichten und Filmen hergestellt werden. Beispielsweise können die erste und/oder zweite Polymerschicht unabhängig voneinander über Extrusion, Rakeln, insbesondere Lösungsrakeln, Schleudern, insbesondere Lackschleudern, oder Sprühen hergestellt werden. Im Rahmen der vorliegenden Erfindung können jedoch auch kommerziell erhältliche Polymerschichten beziehungsweise Polymerfilme als erste und/oder zweite Polymerschicht verwendet werden.

Im Rahmen der vorliegenden Erfindung können die erste und/oder zweite Polymerschicht unabhängig voneinander grundsätzlich aus jedem Polymer beziehungsweise Polymergemisch ausgebildet sein, welches geeignet ist, Ladung über einen langen Zeitraum, beispielsweise einige Monate oder Jahre, zu halten. Zum Beispiel können die erste und/oder zweite Polymerschicht fast beliebige, gleiche oder unterschiedliche Polymermaterialien umfassen oder daraus bestehen. Beispielsweise können die erste und/oder zweite Polymerschicht mindestens ein Polymer, ausgewählt aus der Gruppe bestehend aus Polycarbonaten, perfluorierten oder teilfluorierten Polymeren und Co-Polymeren, wie Polytetrafluoethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren, Polyolefinen, wie Polypropylen, und Mischungen dieser Polymere umfassen oder daraus ausgebildet sein. Derartige Polymere können die eingebrachte Polarisierung vorteilhafterweise über lange Zeit halten. Geeignete Polycarbonate sind beispielsweise durch Reaktion von Kohlensäurederivaten, wie Diphenylcarbonat, Dimethylcarbonat oder Phosgen, mit Polyolen, bevorzugt Diolen, erhältlich. Beispiele für geeignete Diole sind dabei Ethylenglykol, 1,2- Propandiol, 1,3-Propandiol, 1,3-Butandiol, 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, Bisphenol F, Trimethyl-cyclohexyl-bisphenol (Bisphenol-TMC), Mischungen aus diesen und lactonmodifizierte Diole. Bevorzugt sind Polycarbonate, hergestellt aus Bisphenol A, Bisphenol F, Trimethyl- cyclohexyl-bisphenol (Bisphenol-TMC) und Mischungen daraus und ganz besonders bevorzugt sind Polycarbonate basierend auf Bisphenol A. Darüber hinaus können die Polymerschichten unabhängig voneinander ein Homopolymer umfassen oder daraus ausgebildet sein.

Darüber hinaus können die erste und/oder zweite Polymerschicht mindestens ein Additiv zur Verbesserung der Elektret- und/oder elektromechanischen, beispielsweise piezoelektrischen, Eigenschaften umfassen. Das Additiv kann dabei jegliche Polymereigenschaften sowie Parameter verbessern, die eine Auswirkung auf die elektromechanischen, beispielsweise piezoelektrischen, Eigenschaften des Materials haben. Beispielsweise kann das Additiv die Elektreteigenschaften, die Dielektrizitätskonstante, den Elastizitätsmodul, das viskoelastische Verhalten, die Maximaldehnung und/oder die dielektrische Durchschlagsfestigkeit des Polymers beziehungsweise des Polymergemisches verbessern. Vorzugsweise werden ein Additiv oder mehrere Additive eingesetzt, welche die Elektreteigenschaften verbessern, das heißt, welche die Ladungsspeicherfähigkeit erhöhen, die elektrische Leitfähigkeit erniedrigen und/oder die dielektrische Durchschlagsfestigkeit des Polymers erhöhen. Beispielsweise können Tonpartikel, feine keramische Pulver und/oder Weichmacher wie Kohlenwasserstofföle, Mineralöle, Silikonöle und/oder Silikonelastomere, insbesondere mit hohem Molekulargewicht, als Additive eingesetzt werden. Durch die Auswahl von mehreren Additiven können vorteilhafterweise mehrere Materialeigenschaften gleichzeitig verbessert werden.

Die erste und/oder zweite Polymerschicht können im Rahmen der vorliegenden Erfindung, insbesondere im fertig gestellten elektromechanischen Wandler, unabhängig voneinander beispielsweise eine Schichtdicke von ≥ 10 µm bis ≤ 500 µm, bevorzugt von ≥ 20 µm bis ≤ 250 µm, besonders bevorzugt von ≥ 50 µm bis ≤ 200 µm, ganz besonders bevorzugt von ≥ 100 µm bis ≤ 150 µm aufweisen.

Gegebenenfalls können die Polymerschichten vor dem Einsatz in dem erfindungsgemäßen Verfahren oder im Rahmen des erfindungsgemäßen Verfahrens getempert werden.

Das Verfahren kann weiterhin den Verfahrensschritt D): Aufbringen einer Elektrode auf die erste Polymerschicht und einer Elektrode auf die erste und/oder zweite Polymerschicht umfassen. Im Rahmen der vorliegenden Erfindung können die Elektroden jedoch auch bereits zusammen mit den ersten und/oder zweiten Polymerschichten, insbesondere jeweils auf diesen ausgebildet, bereitgestellt werden.

Die Elektroden können mittels dem Fachmann bekannter Verfahren aufgebracht werden. Hierfür kommen beispielsweise Verfahren wie die physikalische Gasphasenabscheidung (englisch: Physical Vapor Deposition, (PVD)), beispielsweise Sputtern, und/oder Aufdampfen, die chemische Gasphasenabscheidung (englisch: Chemical Vapor Deposition, (CVD)), Drucken, Rakeln, Spin-Coaten in Frage. Die Elektroden können auch in vorgefertigter Form aufgeklebt werden.

Bei den Elektrodenmaterialien kann es sich um dem Fachmann bekannte leitfähige Materialien handeln. Hierfür kommen beispielsweise Metalle, Metall-Legierungen, Halbleiter, leitfähige Oligo- oder Polymere, wie Polythiophene, Polyaniline, Polypyrrole, leitfähige Oxide oder Mischoxide, wie Indiumzinnoxid (ITO), oder mit leitfähigen Füllstoffen gefüllte Polymere in Frage. Als Füllstoffe für mit leitfähigen Füllstoffen gefüllte Polymere kommen beispielsweise Metalle, wie Silber, Aluminium und/oder Kupfer, leitfähige Kohlenstoff basierende Materialien, beispielsweise Ruß, Kohlenstoffnanoröhrchen (Carbonanotubes (CNTs)), Graphene oder leitfähige Oligo- oder Polymere, in Frage. Der Füllstoffgehalt der Polymere liegt dabei vorzugsweise oberhalb der Perkolationsschwelle, welche dadurch gekennzeichnet ist, dass die leitfähigen Füllstoffe durchgehende elektrisch leitfähige Pfade ausbilden.

Die Elektroden können im Rahmen der vorliegenden Erfindung auch strukturiert sein. Beispielsweise können die Elektroden derart strukturiert sein, dass der Wandler aktive und passive Bereiche aufweist. Insbesondere können die Elektroden derart strukturiert sein, dass, insbesondere im Sensor-Modus, die Signale ortsaufgelöst detektiert und/oder, insbesondere im Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Das Verfahren kann weiterhin den Verfahrensschritt E): Aufladen der aus dem Verfahrensschritt C) hervorgehenden Anordnung, insbesondere Sandwich-Anordnung, umfassen. Insbesondere können dabei die erste und die zweite Polymerschicht mit Ladungen unterschiedlichen Vorzeichens aufgeladen werden. Das Aufladen kann beispielsweise durch Triboaufladung, Elektronenstrahlbeschuss, Anlegen einer elektrischen Spannung an die Elektroden oder Coronaentladung erfolgen. Insbesondere kann das Aufladen durch eine Zweielektroden-Corona-Anordnung erfolgen. Dabei kann die Nadelspannung mindestens ≥ 20 kV, beispielsweise mindestens ≥ 25 kV, insbesondere mindestens ≥ 30 kV, betragen. Die Aufladezeit kann dabei mindestens ≥ 20 s, beispielsweise mindestens ≥ 30 s, insbesondere mindestens ≥ 1 min, betragen. Im Rahmen der vorliegenden Erfindung kann sowohl erst Verfahrensschritt D) und dann Verfahrensschritt E) als auch erst Verfahrensschritt E) und dann Verfahrensschritt D) durchgeführt werden.

Das Verfahren kann weiterhin den Verfahrensschritt F): Aufeinander Stapeln von zwei oder mehr aus dem Verfahrensschritt C) hervorgehenden Anordnungen, insbesondere Sandwich-Anordnung, umfassen. Dabei können die erste und die zweite Polymerschicht, jeweils mit einer Elektrode kontaktiert werden. Vorzugsweise werden dabei zwei benachbarte Polymerschichten unterschiedlicher aus dem Verfahrensschritt C) hervorgehender Anordnungen mit einer gleichen Polarisation aufgeladen. Insbesondere können dabei zwei benachbarte, Polymerschichten unterschiedlicher aus dem Verfahrensschritt C) hervorgehender Anordnungen die gleiche Elektrode kontaktieren oder mit der gleichen Elektrode kontaktiert werden.

Hinsichtlich weiterer Merkmale eines erfindungsgemäßen Verfahrens wird hiermit explizit auf die Erläuterungen im Zusammenhang mit dem erfindungsgemäßen elektromechanischen Wandler und dessen Verwendung verwiesen.

Ein weiterer Gegenstand der vorliegenden Erfindung ist ein elektromechanischer, beispielsweise piezoelektrischer, Wandler, insbesondere hergestellt durch ein erfindungsgemäßes Verfahren, welcher eine erste Polymerschicht, eine Monolage aus Abstandselementen und eine zweite Polymerschicht umfasst, wobei die Monolage aus Abstandselementen zwischen der ersten Polymerschicht und der zweiten Polymerschicht angeordnet ist, wobei die Abstandselemente der Monolage im Wesentlichen die gleiche Höhe aufweisen und wobei zwischen der ersten Polymerschicht und der zweiten Polymerschicht mindestens ein Hohlraum vorliegt.

Die Abstandselemente können beispielsweise eine sphärolitische oder längliche Form aufweisen. Insbesondere können die Abstandselemente kugelförmig oder strangförmig (fadenförmig) ausgebildet sein. Der Abstand zwischen den Polymerfilmen kann vorteilhafterweise durch die Größe der Abstandselemente bestimmt werden. Die Dichte der Abstandselemente (Anzahl der Abstandselemente pro Flächeneinheit) und die Verteilung der Abstandselemente (mittlerer (maximaler) Abstand der Abstandselemente) kann entsprechend der mechanischen Eigenschaften der Polymerschichten geeignet gewählt werden. Der Hohlraum beziehungsweise die Hohlräume zwischen der ersten und der zweiten Polymerschicht kontaktieren insbesondere auf einer Seite die erste Polymerschicht und auf der anderen Seite die zweite Polymehrschicht.

Die Abstandselemente können in Form von Kugeln, insbesondere von vollen oder hohlen Kugeln, und/oder Strängen, insbesondere von vollen oder hohlen Strängen (Schläuchen), ausgebildet sein.

Vorzugsweise weisen die Abstandselemente eine möglichst geringe Größenverteilung auf. Insbesondere können die Abstandselemente der Monolage nicht nur im Wesentlichen die gleiche Höhe, sondern auch einen im Wesentlichen gleich großen Durchmesser aufweisen. Auf diese Weise kann gewährleistet werden, dass der erste und zweite Polymerfilm äquidistant angeordnet werden können. Die Größe, insbesondere die Höhe und/oder der Durchmesser, der Abstandselemente wird vorzugsweise derart eingestellt, dass sich die Polymerschichten nicht berühren können und/oder dass das nach Fertigstellung resultierende Gesamthohlraumvolumen möglichst groß ist. Beispielsweise können die Abstandselemente eine Höhe von ≥ 1 µm bis ≤ 800 µm, bevorzugt von ≥ 10 µm bis ≤ 300 µm, besonders bevorzugt von ≥ 20 µm bis ≤ 200 µm, ganz besonders bevorzugt von ≥ 50 µm bis ≤100 µm und/oder einen Durchmesser von ≥ 1 µm bis ≤ 800 µm, bevorzugt von ≥ 10 µm bis ≤ 300 µm, besonders bevorzugt von ≥ 20 µm bis ≤ 200 µm, ganz besonders bevorzugt von ≥ 50 µm bis ≤100 µm aufweisen. Vorzugsweise sind die Abstandselemente aus einem elektrisch nicht leitenden und/oder elektrisch nicht polarisierbaren Material ausgebildet.

Die Abstandselemente können sowohl homogen als auch heterogen verteilt auf der ersten Polymerschicht aufgebracht werden. Insbesondere können die Abstandselemente auf der ersten Polymerschicht homogen verteilt aufgebracht werden. In Abhängigkeit vom Anwendungsbereich des herzustellenden elektromechanischen Wandlers, kann es jedoch auch vorteilhaft sein, die Abstandselemente, insbesondere gezielt, ortsaufgelöst heterogen verteilt aufzubringen.

Weiterhin können die Abstandselemente in unterschiedlichen Formen ausgebildet sein. Insbesondere kann eine Vielzahl an in einer ersten Form ausgebildeten Abstandselementen und eine Vielzahl an in einer zweiten Form ausgebildeten Abstandselementen und gegebenenfalls eine Vielzahl an in einer dritten Form ausgebildeten Abstandselementen, et cetera, aufgebracht werden. Dabei können die in unterschiedlichen Formen ausgebildeten Abstandselemente auf der ersten Polymerschicht homogen oder heterogen verteilt aufgebracht werden. Zum anderen können die elektromechanischen, insbesondere piezoelektrischen, Eigenschaften der mit dem erfindungsgemäßen Verfahren hergestellten, elektromechanischen Wandler durch Auswahl der Abstandselementform, Abstandselementanordnung und/oder Abstandselementverteilung angepasst werden.

Die Abstandselemente können grundsätzlich unabhängig voneinander aus jedem Material ausgebildet sein, welches geeignet ist, einen Polungsprozess in den Hohlräumen zu ermöglichen und die nach dem Aufladungsprozess in den Polymerschichten gebildeten Ladungsschichten zu separieren. Insbesondere können die Abstandselemente aus Glas oder einem Polymer ausgebildet sein. Zum Beispiel können die Abstandselemente aus Mineralglas, insbesondere Kieselglas oder Quarzglas, ausgebildet sein. Polymere zur Ausbildung von Abstandselementen können fast beliebig gewählt werden. Exemplarisch seien Thermoplaste, wie Polycarbonate und Polystyrole, insbesondere Polycarbonate, und thermoplastische Elastomere, wie thermoplastische Polyurethane (TPU), genannt. Zum Beispiel vertreibt die Firma Liquid Crystal Technologies (LCT) (Cleveland, Ohio, Vereinigte Staten von Amerika) geeignete polymere Abstandselemente. Beispielsweise können die Abstandselemente in Form von Glaskugeln und/oder Polymerkugeln und/oder Glassträngen und/oder Polymersträngen ausgebildet sein.

Zum Beispiel können die Abstandselemente strangförmig ausgebildet und werden mäanderformig auf der ersten Polymerschicht aufgebracht sein.

Darüber hinaus kann der elektromechanische Wandler eine Versiegelung aufweisen, insbesondere welche den durch die Abstandselemente aufgespannten und an zwei Seiten von den Polymerschichten begrenzten Raum an den übrigen Seiten begrenzt und versiegelt.

Weiterhin kann der elektromechanische Wandler eine oder mehrere Klemmen aufweisen, insbesondere welche die erste und zweite Polymerschicht zusammenklemmen und dadurch die Abstandselemente zwischen der ersten und zweiten Polymerschicht fixieren. Dabei kann die Klemme beziehungsweise können die Klemmen gleichzeitig als Versiegelung ausgestaltet sein.

Die Abstandselemente können in einer unter Ausbildung von Hohlräumen strukturierten Fixierschicht, und/oder auf und/oder teilweise in einer Fixierschicht angeordnet sein.

Beispielsweise kann eine solche Fixierschicht mindestens ein Polymer ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen Polycarbonaten, Polyestern, Copolyestern, Polyamiden, Silikonharzen, Polyurethanen, insbesondere Polyurethanen, und Mischungen dieser Polymere, insbesondere als Bindemittel, umfassen beziehungsweise daraus ausgebildet sein. Insbesondere kann eine solche Fixierschicht ein oder mehrere Einkomponenten-Polyurethane und/oder ein oder mehrere Zweikomponenten-Polyurethane und/oder einen oder mehrere Polyurethan-Schmelzklebstoffe umfassen oder daraus ausgebildet sein.

Bei der ersten und/oder zweiten Polymerschicht handelt es sich vorzugsweise um kompakte und/oder durchgehende Polymerschichten. Dabei bedeutet der Begriff "kompakt" im Sinn der vorliegenden Erfindung, dass die Polymerschichten möglichst wenige, insbesondere keine, Einschlüsse wie Gasblasen aufweisen. Insbesondere kann es sich bei den Polymerschichten um Polymerfilme handeln.

Die erste und/oder zweite Polymerschicht können beispielsweise unabhängig voneinander beispielsweise eine Schichtdicke von ≥ 10 µm bis ≤ 500 µm, bevorzugt von ≥ 20 µm bis ≤ 250 µm, besonders bevorzugt von ≥ 50 µm bis ≤ 200 µm, ganz besonders bevorzugt von ≥ 100 µm bis ≤ 150 µm aufweisen.

Die erste und/oder zweite Polymerschicht kann beispielsweise mindestens ein Polymer, ausgewählt aus der Gruppe bestehend aus Polycarbonaten, perfluorierten oder teilfluorierten Polymeren und Co-Polymeren, wie Polytetrafluoethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren, Polyolefinen, wie Polypropylen, und Mischungen dieser Polymere umfassen oder daraus ausgebildet sein.

Weiterhin kann ein elektromechanischer Wandler mindestens eine weitere Monolage aus Abstandselementen aufweisen, welche, insbesondere deckungsgleich, auf der vorherigen Monolage angeordnet ist. Vorzugsweise ist dabei jeweils ein Abstandselement der weiteren Monolage auf einem entsprechenden Abstandselement der vorherigen Monolage, insbesondere deckungsgleich, angeordnet. Auf diese Weise kann zwischen der ersten und zweiten Polymerschicht mindestens ein, insbesondere durchgängiger, Hohlraum vorliegen. Vorzugsweise weisen die Abstandselemente der weiteren Monolage dabei, insbesondere untereinander, ebenfalls im Wesentlichen die gleiche Höhe auf. Die weitere Monolage ist insbesondere ebenfalls zwischen der ersten Polymerschicht und der zweiten Polymerschicht angeordnet.

Vorzugsweise umfasst ein elektromechanischer Wandler weiterhin zwei Elektroden, insbesondere Elektrodenschichten, wobei eine Elektrode die erste Polymerschicht und die andere Elektrode die zweite Polymerschicht kontaktiert. Weiterhin können die erste Polymerschicht und die zweite Polymerschicht eine elektrische Ladung mit unterschiedlichem Vorzeichen aufweisen. Insbesondere kann ein erfindungsgemäßer elektromechanischer Wandler zwei oder mehr aufeinander gestapelte Anordnungen, insbesondere Sandwich-Anordnung, umfassen, welche jeweils eine erste Polymerschicht, eine Monolage aus Abstandselementen und eine zweite Polymerschicht umfassen, wobei die Monolage aus Abstandselementen zwischen der ersten Polymerschicht und der zweite Polymerschicht angeordnet ist, wobei die Abstandselemente der Monolage im Wesentlichen die gleiche Höhe aufweisen und wobei zwischen der ersten Polymerschicht und der zweiten Polymerschicht mindestens ein Hohlraum vorliegt. Dabei können die erste und die zweite Polymerschicht jeweils eine Elektrode kontaktieren. Vorzugsweise weisen dabei zwei benachbarte Polymerschichten unterschiedlicher Anordnungen die gleiche Ladungspolarisation auf. Insbesondere können dabei zwei benachbarte Polymerschichten unterschiedlicher Anordnungen die gleiche Elektrode kontaktieren.

Hinsichtlich weiterer Merkmale eines erfindungsgemäßen elektromechanischen Wandlers wird hiermit explizit auf die Erläuterungen im Zusammenhang mit dem erfindungsgemäßen Verfahren und der erfindungsgemäßen Verwendung verwiesen.

Ein weiterer Gegenstand der vorliegenden Erfindung ist die Verwendung eines erfindungsgemäßen Wandlers als Sensor, Generator und/oder Aktuator, beispielsweise im elektromechanischen und/oder elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen.

Hinsichtlich weiterer Merkmale einer erfindungsgemäßen Verwendung wird hiermit explizit auf die Erläuterungen im Zusammenhang mit dem erfindungsgemäßen Verfahren und dem erfindungsgemäßen elektromechanischen Wandler verwiesen.

### Zeichnungen und Versuchsbeschreibung

Die erfindungsgemäße Herstellung und der Aufbau eines erfindungsgemäßen elektromechanischen, beispielsweise piezoelektrischen, Wandlers wird anhand der Zeichnungen und der folgenden Zeichnungsbeschreibung näher erläutert. Dabei ist zu beachten, dass die Zeichnungen und die Versuchsbeschreibungen nur einen beschreibenden Charakter haben und nicht dazu gedacht sind, die Erfindung in irgendeiner Form einzuschränken.

### Zeichnungen

Es zeigen:
- Fig. 1: einen schematischen Querschnitt durch eine erste Ausführungsform eines erfindungsgemäßen elektromechanischen Wandlers, dessen Polymerschichten aus einem thermoplastischen Material ausgebildet sind;
- Fig. 2: einen schematischen Querschnitt durch eine zweite Ausführungsform eines erfindungsgemäßen elektromechanischen Wandlers, dessen Abstandselemente aus einem thermoplastischen Material ausgebildet sind;
- Fig. 3: einen schematischen Querschnitt durch eine dritte Ausführungsform eines erfindungsgemäßen elektromechanischen Wandlers, dessen Abstandselemente als Füllstoffe in einem Druckmaterial aufgebracht wurden;
- Fig. 4: einen schematischen Querschnitt durch eine vierte Ausführungsform eines erfindungsgemäßen elektromechanischen Wandlers, dessen Abstandselemente mittels einer strukturierten Klebemittelschicht beziehungsweise einer thermoplastischen Schicht fixiert sind; und
- Fig. 5: einen schematischen Querschnitt durch eine fünfte Ausführungsform eines erfindungsgemäßen elektromechanischen Wandlers, dessen Abstandselemente durch Zusammenklemmen der Polymerschichten mit Klemmen fixiert sind.

Figur 1 zeigt einen schematischen Querschnitt durch eine erste Ausführungsform eines erfindungsgemäßen elektromechanischen Wandlers, welcher eine erste Polymerschicht 1, eine Monolage aus Abstandselementen 3 und eine zweite Polymerschicht 2 umfasst. Figur 1 zeigt, dass die Monolage aus Abstandselementen 3 zwischen der ersten Polymerschicht 1 und der zweiten Polymerschicht 2 angeordnet ist, wobei die Abstandselemente 3 der Monolage im Wesentlichen die gleiche Höhe h aufweisen. Dabei bedeutet "im Wesentlichen" insbesondere, dass fertigungsbedingete Höhenunterschiede umfasst sind. Figur 1 zeigt weiterhin, dass zwischen der ersten Polymerschicht 1 und der zweiten Polymerschicht 2 ein Hohlraum 4 vorliegt.

Im Rahmen der gezeigten, ersten Ausführungsform des erfindungsgemäßen elektromechanischen Wandlers sind die erste 1 und zweite 2 Polymerschicht aus einem thermoplastischen Material ausgebildet. Die Abstandselemente 3 sind dabei aus einem nicht-thermoplastischen Material ausgebildet und wurden durch ein Laminierungsverfahren fixiert, bei welchem die Abstandselemente 3 bei erhöhter Temperatur und Druck in die thermoplastischen Polymerschichten 1, 2 gedrückt und die thermoplastischen Polymerschichten 1, 2 verformt wurden.

Figur 2 zeigt einen schematischen Querschnitt durch eine zweite Ausführungsform eines erfindungsgemäßen elektromechanischen Wandlers, welche sich von der ersten Ausführungsform im Wesentlichen dadurch unterscheidet, dass anstelle der ersten und zweiten Polymerschicht 1, 2 die Abstandselemente 3 aus einem thermoplastischen Material ausgebildet sind. Figur 2 zeigt, dass die thermoplastischen Abstandselemente 3 durch ein Laminierungsverfahren bei erhöhter Temperatur und Druck verformt und zwischen der ersten 1 und zweiten 2 Polymerschicht fixiert sind.

Figur 3 zeigt einen schematischen Querschnitt durch eine dritte Ausführungsform eines erfindungsgemäßen elektromechanischen Wandlers, welche sich im Wesentlichen dadurch von der ersten und zweiten Ausführungsform unterscheidet, dass die Abstandselemente 3 als Füllstoffe in einem Druckmaterial 5 durch ein Druckverfahren auf die erste Polymerschicht 1 aufgebracht wurden und in einer unter Ausbildung von Hohlräumen 4 strukturierten Fixierschicht 5 vorliegen, welche die erste 1 und zweite 2 Polymerschicht miteinander verbindet.

Figur 4 zeigt einen schematischen Querschnitt durch eine vierte Ausführungsform eines erfindungsgemäßen elektromechanischen Wandlers, welche sich von der dritten Ausführungsform im Wesentlichen dadurch unterscheidet, dass die Abstandselemente 3 durch ein Klebeverfahren (oder Laminierungsverfahren) mittels strukturierter Klebeschichten (oder thermoplastischer Schichten) 5 auf der ersten 1 und zweiten 2 Polymerschicht fixiert sind.

Figur 5 einen schematischen Querschnitt durch eine fünfte Ausführungsform eines erfindungsgemäßen elektromechanischen Wandlers, der sich von den übrigen Ausführungsformen im Wesentlichen dadurch unterscheidet, dass dieser Klemmen 6 aufweist, welche die Polymerschichten 1, 2 zusammenklemmen und dadurch die Abstandselemente 3 zwischen den Polymerschichten 1, 2 fixieren. Figur 5 zeigt weiterhin, dass die Klemmen gleichzeitig als Versiegelung ausgestaltet sind, welche den durch die Abstandselemente 3 aufgespannten und an zwei Seiten von den Polymerschichten 1, 2 begrenzten Hohlraum 4 an den übrigen Seiten begrenzen und versiegeln

## Patentansprüche

1. Verfahren zur Herstellung eines elektromechanischen Wandlers, umfassend die Schritte:
A) Aufbringen einer Monolage aus Abstandselementen (3) auf eine erste Polymerschicht (1), wobei die Abstandselemente (3) der Monolage im Wesentlichen die gleiche Höhe (h) aufweisen,
B) Aufbringen einer zweiten Polymerschicht (2) auf die Abstandselemente (3) der Monolage, so dass zwischen der ersten Polymerschicht (1) und der zweiten Polymerschicht (2) mindestens ein Hohlraum (4) vorliegt, und
C) Fixieren der Abstandselemente (3) zwischen der ersten (1) und zweiten (2) Polymerschicht.

2. Verfahren nach Anspruch 1, wobei die Abstandselemente (3) in Form von Kugeln und/oder Strängen ausgebildet sind.

3. Verfahren nach Anspruch 1, wobei die Abstandselemente (3) strangförmig ausgebildet sind und mäanderförmig auf die erste Polymerschicht (1) aufgebracht werden.

4. Verfahren nach Anspruch 1, wobei die Abstandselemente (3) aus Glas oder einem Polymer ausgebildet sind.

5. Verfahren nach Anspruch 1, wobei die Abstandselemente (3) eine Höhe (h) von ≥ 1 µm bis ≤ 800 µm und/oder einen Durchmesser von ≥ 1 µm bis ≤ 800 µm aufweisen.

6. Verfahren nach Anspruch 1, wobei das Aufbringen der Abstandselemente (3) auf die erste Polymerschicht (1) in Verfahrensschritt A) durch ein Streuverfahren und/oder ein Sprühverfahren und/oder ein Wirbelschichtverfahren und/oder ein Bestückungsverfahren und/oder ein Druckverfahren und/oder ein Beschichtungsverfahren erfolgt.

7. Verfahren nach Anspruch 1, wobei das Aufbringen der Abstandselemente (3) auf die erste Polymerschicht (1) in Verfahrensschritt A) durch ein Druck- und/oder Beschichtungsverfahren erfolgt, wobei ein Druck- und/oder Beschichtungsmaterial eingesetzt wird, welches die Abstandselemente (3) als Füllstoffe umfasst.

8. Verfahren nach Anspruch 7, wobei das Fixieren der Abstandelemente (3) durch nur teilweises Verfestigen des Abstandselemente (3) umfassenden Druck- und/oder Beschichtungsmaterials (5) nach dem Aufbringen der Monolage aus Abstandselementen in Verfahrensschritt A) und vollständiges Verfestigen des Abstandselemente (3) umfassenden Druck- und/oder Beschichtungsmaterials (5) nach dem Aufbringen der zweiten Polymerschicht (2) in Verfahrensschritt B) erfolgt.

9. Verfahren nach Anspruch 1, wobei das Fixieren der Abstandelemente (3)
- durch ein Klebeverfahren erfolgt, wobei vor dem Verfahrensschritt A) im Verfahrensschritt 0) auf die Abstandselemente (3) und/oder die erste Polymerschicht (1) und/oder die zweite Polymerschicht (2) eine Klebemittelschicht (5) durch Aufbringen eines Druck- und/oder Beschichtungsmaterials durch ein Druck- und/oder Beschichtungsverfahren aufgebracht wird, und/oder
- durch ein Laminierungsverfahren erfolgt, wobei
vor dem Verfahrensschritt A) im Verfahrensschritt 0) auf die Abstandselemente (3) und/oder die erste Polymerschicht (1) und/oder die zweite Polymerschicht (2) eine thermoplastische Schicht (5) durch Aufbringen eines Druck- und/oder Beschichtungsmaterials durch ein Druck- und/oder Beschichtungsverfahren aufgebracht wird, und/oder
die Abstandselemente (3) und/oder die erste Polymerschicht (1) und/oder die zweite Polymerschicht (2) aus einem thermoplastischen Material ausgebildet sind, und/oder
- durch ein Klemmverfahren erfolgt, wobei die erste Polymerschicht (1) und die zweite Polymerschicht (2) durch eine Klemme (6) zusammengeklemmt werden.

10. Verfahren nach Anspruch 7 oder 9, wobei das Druck- und/oder Beschichtungsmaterial mindestens ein Polymer, ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharzen, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen dieser Polymere, umfasst.

11. Verfahren nach Anspruch 7 oder 9, wobei das Druck- und/oder Beschichtungsmaterial ein oder mehrere Einkomponenten-Polyurethane und/oder ein oder mehrere Zweikomponenten-Polyurethane und/oder eine oder mehrer wässrige Polyurethandispersionen und/oder einen oder mehrere Polyurethan-Schmelzklebstoffe umfasst.

12. Verfahren nach Anspruch 9, wobei die Klebemittelschicht (5) und/oder die thermoplastische Schicht (5) eine strukturierte Schicht ist.

13. Verfahren nach Anspruch 9, wobei das Verfahren nach dem Verfahrensschritt A) den Verfahrensschritt A1):
Entfernen von nicht auf der Klebemittelschicht (5) und/oder thermoplastischen Schicht (5) haftenden Abstandselementen (3)
umfasst.

14. Elektromechanischer Wandler, umfassend
- eine erste Polymerschicht (1),
- eine Monolage aus Abstandselementen (3), und
- eine zweite Polymerschicht (2),
wobei die Monolage aus Abstandselementen (3) zwischen der ersten Polymerschicht (1) und der zweite Polymerschicht (2) angeordnet ist,
wobei die Abstandselemente (3) der Monolage im Wesentlichen die gleiche Höhe (h) aufweisen und
wobei zwischen der ersten Polymerschicht (1) und der zweiten Polymerschicht (2) mindestens ein Hohlraum (4) vorliegt.

## Claims

1. Method for producing an electromechanical transducer, comprising the steps of:
A) applying a monolayer of spacer elements (3) onto a first polymer layer (1), the spacer elements (3) of the monolayer having essentially the same height (h),
B) applying a second polymer layer (2) onto the spacer elements (3) of the monolayer so that there is at least one cavity (4) between the first polymer layer (1) and the second polymer layer (2), and
C) fixing the spacer elements (3) between the first (1) and second (2) polymer layers.

2. Method according to Claim 1, wherein the spacer elements (3) are configured in the form of spheres and/or rods.

3. Method according to Claim 1, wherein the spacer elements (3) are configured in rod form and are applied in a meandering fashion onto the first polymer layer (1).

4. Method according to Claim 1, wherein the spacer elements (3) are made of glass or a polymer.

5. Method according to Claim 1, wherein the spacer elements (3) have a height (h) of from ≥ 1 µm to ≤ 800 µm and/or a diameter of from ≥ 1 µm to ≤ 800 µm.

6. Method according to Claim 1, wherein the application of the spacer elements (3) onto the first polymer layer (1) in method step A) is carried out by a scattering method and/or a spray method and/or a fluidised bed method and/or a placement method and/or a printing method and/or a coating method.

7. Method according to Claim 1, wherein the application of the spacer elements (3) onto the first polymer layer (1) in method step A) is carried out by a printing and/or coating method, a printing and/or coating material which comprises the spacer elements (3) as fillers being used.

8. Method according to Claim 7, wherein the fixing of the spacer elements (3) is carried out by only partial consolidation of the printing and/or coating material (5) comprising spacer elements (3) after application of the monolayer of spacer elements in method step A), and full consolidation of the printing and/or coating material (5) comprising spacer elements (3) after application of the second polymer layer (2) in method step B).

9. Method according to Claim 1, wherein the fixing of the spacer elements (3)
- is carried out by an adhesive bonding method, a layer (5) of adhesive being applied onto the spacer elements (3) and/or the first polymer layer (1) and/or the second polymer layer (2) in method step 0) before method step A) by applying a printing and/or coating material by a printing and/or coating method, and/or
- is carried out by a lamination method,
a thermoplastic layer (5) being applied onto the spacer elements (3) and/or the first polymer layer (1) and/or the second polymer layer (2) in method step 0) before method step A) by applying a printing and/or coating material by a printing and/or coating method, and/or
the spacer elements (3) and/or the first polymer layer (1) and/or the second polymer layer (2) being made of a thermoplastic material, and/or
- is carried out by a clamping method, the first polymer layer (1) and the second polymer layer (2) being clamped together by a clamp (6).

10. Method according to Claim 7 or 9, wherein the printing and/or coating material comprises at least one polymer selected from the group consisting of cellulose esters, cellulose ethers, rubber derivatives, polyester resins, unsaturated polyesters, alkyd resins, phenolic resins, amino resins, amido resins, ketone resins, xylene-formaldehyde resins, epoxy resins, phenoxy resins, polyolefins, polyvinyl chloride, polyvinyl esters, polyvinyl alcohols, polyvinyl acetals, polyvinyl ethers, polyacrylates, polymethacrylates, polystyrenes, polycarbonates, polyesters, copolyesters, polyamides, silicone resins, polyurethanes and blends of these polymers.

11. Method according to Claim 7 or 9, wherein the printing and/or coating material comprises one or more single-component polyurethanes and/or one or more two-component polyurethanes and/or one or more aqueous polyurethane dispersions and/or one or more polyurethane hot-melt adhesives.

12. Method according to Claim 9, wherein the layer (5) of adhesive and/or the thermoplastic layer (5) is a structured layer.

13. Method according to Claim 9, wherein after method step A), the method comprises method step A1):
removing spacer elements (3) which do not adhere to the layer (5) of adhesive and/or the thermoplastic layer (5).

14. Electromechanical transducer, comprising
- a first polymer layer (1),
- a monolayer of spacer elements (3), and
- a second polymer layer (2),
the monolayer of spacer elements (3) being arranged between the first polymer layer (1) and the second polymer layer (2),
the spacer elements (3) of the monolayer having essentially the same height (h), and
there being at least one cavity (4) between the first polymer layer (1) and the second polymer layer (2).

## Revendications

1. Procédé pour la fabrication d'un transformateur électromécanique, comprenant les étapes :
A) application d'une monocouche constituée par des éléments d'écartement (3) sur une première couche de polymère (1), les éléments d'écartement (3) de la monocouche présentant sensiblement la même hauteur (h),
B) application d'une deuxième couche de polymère (2) sur les éléments d'écartement (3) de la monocouche, de manière telle qu'au moins un espace creux (4) se trouve entre la première couche de polymère (1) et la deuxième couche de polymère (2), et
C) fixation des éléments d'écartement (3) entre la première (1) et la deuxième (2) couche de polymère.

2. Procédé selon la revendication 1, les éléments d'écartement (3) étant réalisés sous forme de billes et/ou de brins.

3. Procédé selon la revendication 1, les éléments d'écartement (3) étant réalisés sous forme de brin et appliqués sous forme de méandres sur la première couche de polymère (1).

4. Procédé selon la revendication 1, les éléments d'écartement (3) étant réalisés en verre ou en polymère.

5. Procédé selon la revendication 1, les éléments d'écartement (3) présentant une hauteur (h) ≥ 1 µm à ≤ 800 µm et/ou un diamètre ≥ 1 µm à ≤ 800 µm.

6. Procédé selon la revendication 1, l'application des éléments d'écartement (3) sur la première couche de polymère (1) dans l'étape de procédé A) ayant lieu par un procédé de saupoudrage et/ou un procédé de pulvérisation et/ou un procédé par couche tourbillonnante et/ou un procédé de pose de composants et/ou un procédé d'impression et/ou un procédé de revêtement.

7. Procédé selon la revendication 1, l'application des éléments d'écartement (3) sur la première couche de polymère (1) dans l'étape de procédé A) ayant lieu par un procédé d'impression et/ou un procédé de revêtement, un matériau d'impression et/ou de revêtement étant utilisé, qui comprend les éléments d'écartement (3) en tant que charges.

8. Procédé selon la revendication 7, la fixation des éléments d'écartement (3) ayant lieu par une solidification seulement partielle du matériau d'impression et/ou de revêtement (5) comprenant les éléments d'écartement (3) après l'application de la monocouche d'éléments d'écartement dans l'étape de procédé A) et par solidification complète du matériau d'impression et/ou de revêtement (5) comprenant les éléments d'écartement (3) après application de la deuxième couche de polymère (2) dans l'étape de procédé B).

9. Procédé selon la revendication 1, la fixation des éléments d'écartement (3)
- ayant lieu par un procédé de collage, une couche d'adhésif (5) étant appliquée avant l'étape de procédé A) dans l'étape de procédé 0) sur les éléments d'écartement (3) et/ou sur la première couche de polymère (1) et/ou sur la deuxième couche de polymère (2) par application d'un matériau d'impression et/ou de revêtement par un procédé d'impression et/ou de revêtement, et/ou
- ayant lieu par un procédé de laminage, où
on applique une couche thermoplastique (5) avant l'étape de procédé A) dans l'étape de procédé 0) sur les éléments d'écartement (3) et/ou sur la première couche de polymère (1) et/ou sur la deuxième couche de polymère (2) par application d'un matériau d'impression et/ou de revêtement par un procédé d'impression et/ou de revêtement, et/ou
les éléments d'écartement (3) et/ou la première couche polymère (1) et/ou la deuxième couche polymère (2) est/sont formé(e)s par un matériau thermoplastique, et/ou
- ayant lieu par un procédé de serrage, la première couche de polymère (1) et la deuxième couche de polymère (2) étant serrées ensemble par une pince (6).

10. Procédé selon la revendication 7 ou 9, le matériau d'impression et/ou de revêtement comprenant au moins un polymère, choisi dans le groupe constitué par les esters de cellulose, les éthers de cellulose, les dérivés de caoutchouc, les résines polyester, les polyesters insaturés, les résines alkyde, les résines phénoliques, les résines amino, les résines amido, les résines cétone, les résines de xylène-formaldéhyde, les résines époxyde, les résines phénoxy, les polyoléfines, le poly(chlorure de vinyle), les poly(esters de vinyle), les poly(alcools vinyliques), les polyvinylacétals, les polyvinyléthers, les polyacrylates, les polyméthacrylates, les polystyrènes, les polycarbonates, les polyesters, les copolyesters, les polyamides, les résines siliconées, les polyuréthanes et les mélanges de ces polymères.

11. Procédé selon la revendication 7 ou 9, le matériau d'impression et/ou de revêtement comprenant un ou plusieurs polyuréthanes à un composant et/ou un ou plusieurs polyuréthanes à deux composants et/ou une ou plusieurs dispersions aqueuses de polyuréthane et/ou un ou plusieurs adhésifs en masse fondue de polyuréthane.

12. Procédé selon la revendication 9, la couche d'adhésif (5) et/ou la couche thermoplastique (5) étant une couche structurée.

13. Procédé selon la revendication 9, le procédé comprenant, après l'étape de procédé A), l'étape de procédé A1) :
élimination des éléments d'écartement (3) n'adhérant pas sur la couche d'adhésif (5) et/ou la couche thermoplastique (5).

14. Transformateur électromécanique, comprenant
- une première couche de polymère (1),
- une monocouche d'éléments d'écartement (3), et
- une deuxième couche de polymère (2),
la monocouche d'éléments d'écartement (3) étant disposée entre la première couche de polymère (1) et la deuxième couche de polymère (2),
les éléments d'écartement (3) de la monocouche présentant sensiblement la même hauteur (h) et
au moins un espace creux (4) se trouvant entre la première couche de polymère (1) et la deuxième couche de polymère (2).
